# EUROPEAN PATENT APPLICATION

(11) **EP 4 618 720 A1**
(43) Date of publication of application: **17.09.2025**
(21) Application number: 24199676.8
(22) Date of filing: 11.09.2024
(51) Int. Cl.: H10D 62/83, H10D 62/832, B82Y 10/00

(54) **STRUCTURES INCLUDING AN ISOTOPICALLY-DEPLETED SEMICONDUCTOR LAYER**

(30) Priority: 13.03.2024 US 202418603348
(71) Applicant: GlobalFoundries U.S. Inc., Malta, NY 12020 (US)
(72) Inventor: Cave, Nigel Graeme, Malta, 12020 (US); Grass, Carsten Bernd, 01109 Dresden (DE); Mazurier, Jérôme, 01109 Dresden (DE); Baars, Peter, 01109 Dresden (DE)
(74) Representative: Grünecker Patent- und Rechtsanwälte PartG mbB

(57) **Abstract**

Semiconductor structures (10) including isotopically-enriched silicon, germanium and/or silicon-germanium layers for use in spin qubit devices, as well as corresponding methods, are disclosed. The method comprises providing a silicon, germanium or silicon-germanium on insulator (SOI, GOI, SGOI) substrate (12, 14, 16) and depositing a layer of nuclear-spin free semiconductor material (18) thereon. A subsequent anneal causes 29-Si and/or 73-Ge to diffuse into the enriched layer, leaving the device layer with less nuclear spin isotopes. The resulting qubit device comprises a semiconductor device layer (12) having a concentration of a nuclear-spin carrying isotope that is less than a natural abundance of the first isotope and greater than zero parts per million.

## Description

### BACKGROUND

The disclosure relates generally to semiconductor devices and integrated circuit fabrication and, in particular, to structures that include an isotopically-depleted semiconductor layer and methods of forming such structures.

A quantum computer fabricated in silicon may be premised upon controlling the spin of charge carriers in a quantum device known as a spin qubit. A spin qubit may be characterized by a pair of spin states that provide binary digits of "0" or "1" or a superposition of both "0" and "1". For example, the spin of an electron in a spin qubit may have a spin-up state and a spin-down state and these two natural states makes them favorable candidates as qubits for quantum computing.

An isotope is any of multiple species of atoms of an element having the same atomic number and nearly identical chemical behavior but with differing mass numbers and different physical properties. Natural silicon is characterized by three stable isotopes with mass number 28, mass number 29, and mass number 30. Silicon atoms of mass number 28 is the most abundant isotope and has a nuclear spin of zero. The less abundant isotope of silicon with mass number 30 is also spin-free. Neither of these spin-free isotopes of silicon interacts with a spin qubit. However, silicon atoms with mass number 29 have a non-integer nuclear spin of one-half that has been found to degrade the performance of a spin qubit. For example, the nuclear spin of silicon atoms with mass number 29 may decohere qubit spin states and render then unstable. Hence, reducing the concentration of the isotope of silicon with mass number 29 in the channel of a qubit may therefore be beneficial.

Improved structures that include an isotopically-depleted semiconductor layer and methods of forming such structures are needed.

### SUMMARY

In an embodiment of the invention, a structure comprises a semiconductor layer comprising a semiconductor material having an isotope with a concentration of atoms that is less than a natural abundance of the isotope and greater than zero parts per million.

In an embodiment of the invention, a method comprises forming a semiconductor layer comprising a semiconductor material having an isotope with a concentration of atoms that is less than a natural abundance of the isotope and greater than zero parts per million.

### BRIEF DESCRIPTION OF THE DRAWINGS

The accompanying drawings, which are incorporated in and constitute a part of this specification, illustrate various embodiments of the invention and, together with a general description of the invention given above and the detailed description of the embodiments given below, serve to explain the embodiments of the invention.
FIG. 1 is a cross-sectional view of a structure at an initial fabrication stage of a processing method in accordance with embodiments of the invention.
FIG. 2 is a cross-sectional view of the structure at a fabrication stage subsequent to FIG. 1.
FIG. 3 is a cross-sectional view of the structure at a fabrication stage subsequent to FIG. 2.
FIG. 3A is a cross-sectional view of an electronic device in accordance with alternative embodiments of the invention.
FIG. 4 is a cross-sectional view of a structure at an initial fabrication stage in accordance with alternative embodiments of the invention.
FIG. 5 is a cross-sectional view of the structure at a fabrication stage subsequent to FIG. 4.

### DETAILED DESCRIPTION

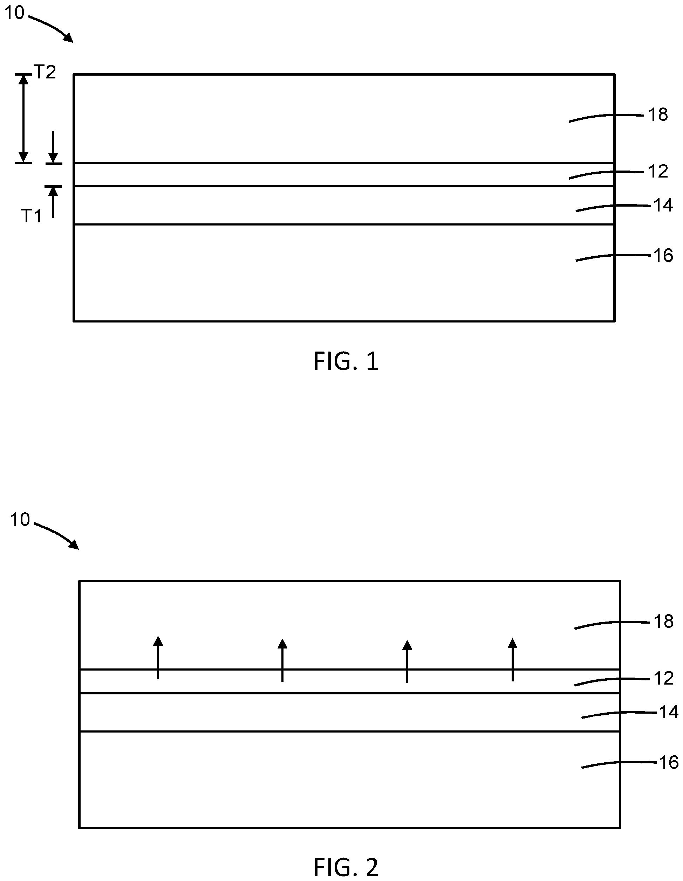

With reference to FIG. 1 and in accordance with embodiments of the invention, a structure 10 may be formed using a silicon-on-insulator substrate that includes a semiconductor layer 12, a buried insulator layer 14, and a semiconductor substrate 16. The buried insulator layer 14 may be comprised of a dielectric material, such as silicon dioxide, that is an electrical insulator. The semiconductor substrate 16 may be comprised of a semiconductor material, such as single-crystal silicon. The buried insulator layer 14 is disposed between the semiconductor layer 12 and the semiconductor substrate 16. The buried insulator layer 14 has a lower interface with the semiconductor substrate 16 and an upper interface with the semiconductor layer 12.

The semiconductor layer 12 may be significantly thinner than the semiconductor substrate 16. In an embodiment, the semiconductor layer 12 may have a thickness T1 in a range of about 3 nanometers to about 8 nanometers. In an embodiment, the semiconductor layer 12 may be thinned to the thickness T1 from an initially larger thickness. The semiconductor layer 12 may be comprised of a single-crystal semiconductor material, such as single-crystal silicon, over the entire thickness T1.

In an embodiment, the single-crystal semiconductor material of the semiconductor layer 12 may include different stable isotopes that are present in their respective natural abundances. For example, the semiconductor layer 12 may contain silicon atoms with mass number 28 at a natural abundance of 92.2 atom percent, silicon atoms with mass number 29 at a natural abundance of 4.7 atom percent (47000 parts per million), and silicon atoms with mass number 30 at a natural abundance of 3.1 atom percent (31000 parts per million).

A semiconductor layer 18 may be formed with a thickness T2 on the semiconductor layer 12. In an embodiment, the thickness T2 of the semiconductor layer 18 may be greater than the thickness T1 of the semiconductor layer 12. In an embodiment, the semiconductor layer 18 may be deposited with a thickness T2 in a range of 50 nanometers to 150 nanometers. The semiconductor layer 18 may be comprised of a single-crystal semiconductor material, such as single-crystal silicon, over the entire thickness T2. In an embodiment, the semiconductor layer 18 may be a homoepitaxial layer that is comprised of the same semiconductor material as the semiconductor layer 12.

In an embodiment, the semiconductor layer 18 may be comprised of single-crystal silicon that is depleted of silicon atoms with mass number 29 and a non-integer spin of one-half (1/2). In an embodiment, the semiconductor layer 18 may be comprised of single-crystal silicon containing a concentration of silicon atoms with mass number 29 that is less than the natural abundance of silicon atoms with mass number 29 and a non-integer spin of one-half (1/2). In an embodiment, the semiconductor layer 18 may contain less than or equal to 100 parts per million of silicon atoms with mass number 29. In an embodiment, the semiconductor layer 18 may contain less than or equal to 50 parts per million of silicon atoms with mass number 29. Due to the depletion of silicon atoms with mass number 29, the semiconductor layer 18 is enriched in silicon atoms with mass number 28 above (i.e., greater than) the natural abundance.

The semiconductor layer 18 may be formed by an epitaxial growth process. The single-crystal semiconductor material of the semiconductor layer 12 has a crystal structure that serves as a crystalline template during epitaxial growth for the crystal structure of the single-crystal semiconductor material of the semiconductor layer 18. The semiconductor layer 18 may be deposited by chemical vapor deposition using a silicon-containing source that is depleted of silicon with mass number 29. In an embodiment, the semiconductor layer 18 may be deposited as an epitaxial coating using a silicon-containing source containing less than or equal to 1000 parts per million of silicon with mass number 29. In an embodiment, the semiconductor layer 18 may be deposited as an epitaxial coating using a silicon-containing source containing less than or equal to 50 parts per million of silicon with mass number 29.

In an alternative embodiment, the buried insulator layer 14 may be comprised of silicon dioxide that is depleted of silicon atoms with mass number 29 below the natural abundance. In an alternative embodiment, the semiconductor layer 18 may be deposited and recrystallized by an anneal to form single-crystal semiconductor material.

With reference to FIG. 2 in which like reference numerals refer to like features in FIG. 1 and at a subsequent fabrication stage, an anneal is performed that causes silicon atoms with mass number 29 to diffuse, as diagrammatically indicated by the single-headed arrows, from the single-crystal semiconductor material of the semiconductor layer 12 into the single-crystal semiconductor material of the semiconductor layer 18. In an embodiment, the anneal may be performed at a temperature of about 1175°C for two minutes in a hydrogen or oxygen atmosphere. In an embodiment, the temperature for the anneal may in a range from 950°C to 1100°C. During the anneal, silicon atoms with mass number 29 move by diffusion from the region of higher concentration in the semiconductor layer 12 to the region of lower concentration in the semiconductor layer 18.

The concentration of silicon atoms with mass number 29 originally present in the thickness T1 of the semiconductor layer 12 is redistributed and diluted by diffusion over the sum of the thickness T1 of the semiconductor layer 12 and the thickness T2 of the semiconductor layer 18. The concentration of silicon atoms with mass number 29 within the composite semiconductor layers 12, 18 is less than the natural abundance of silicon atoms with mass number 29. In an embodiment, the concentration of silicon atoms with mass number 29 within the composite semiconductor layers 12, 18 may be uniformly diluted to a numerical value that is less than the natural abundance of silicon atoms with mass number 29. In an embodiment, the concentration of silicon atoms with mass number 29 in the composite semiconductor layers 12, 18 is less than the natural abundance of silicon atoms with mass number 29 and greater than zero atom percent (0 parts per million). In an embodiment, the concentration of silicon atoms with mass number 29 in the composite semiconductor layers 12, 18 is less than the natural abundance of silicon atoms with mass number 29 and greater than 0.0005 atom percent (5 parts per million). In an embodiment, the concentration of silicon atoms with mass number 29 in the composite semiconductor layers 12, 18 is less than half of the natural abundance of silicon atoms with mass number 29 and greater than zero atom percent (0 parts per million). In an embodiment, the concentration of silicon atoms with mass number 29 in the composite semiconductor layers 12, 18 is less than half of the natural abundance of silicon atoms with mass number 29 and greater than 0.0005 atom percent (5 parts per million). After the anneal, the single-crystal silicon of the composite semiconductor layers 12, 18 is enriched in silicon atoms with mass number 28 above (i.e., greater than) the natural abundance of silicon atoms with mass number 28.

The concentration of silicon atoms with mass number 29 distributed in the composite semiconductor layers 12, 18, after the anneal, decreases with an increasing thickness T2 of the semiconductor layer 18. The post-anneal concentration of silicon atoms with mass number 29 in the semiconductor layer 18 is greater than the pre-anneal concentration of silicon atoms with mass number 29 in the semiconductor layer 18 due to diffusion of silicon atoms with mass number 29 from the semiconductor layer 12 into the semiconductor layer 18. The post-anneal concentration of silicon atoms with mass number 29 in the semiconductor layer 12 is less than the pre-anneal concentration of silicon atoms with mass number 29 in the semiconductor layer 12 due to diffusion of silicon atoms with mass number 29 from the semiconductor layer 12 into the semiconductor layer 18.

In an alternative embodiment, the semiconductor layer 12 may be initially comprised of single-crystal germanium with its stable isotopes present in their respective natural abundances, and the semiconductor layer 18 may be comprised of single-crystal germanium that is depleted in one or more of the stable isotopes. For example, the semiconductor layer 12 may contain atoms of germanium with mass number 70 at a natural abundance of 20.6 atom percent, atoms of germanium with mass number 72 at a natural abundance of 27.5 atom percent, atoms of germanium with mass number 73 at a natural abundance of 7.8 atom percent, atoms of germanium with mass number 74 at a natural abundance of 36.5 atom percent, and atoms of germanium with mass number 76 at a natural abundance of 7.7 atom percent. In an alternative embodiment, the semiconductor layer 12 may initially include germanium atoms with mass number 73, which has a non-integer nuclear spin of 9/2, at a concentration that is equal to the natural abundance of germanium atoms with mass number 73. In an embodiment, the semiconductor layer 18 may contain germanium that is depleted of germanium atoms with mass number 73 below the natural abundance of germanium atoms with mass number 73.

After the anneal, the concentration of germanium atoms with mass number 73 within the composite semiconductor layers 12, 18 is reduced to less than the natural abundance of germanium atoms with mass number 73. In an embodiment, the concentration of germanium atoms with mass number 73 within the composite semiconductor layers 12, 18 may be uniformly diluted to a numerical value that is less than the natural abundance of germanium atoms with mass number 73. The composite semiconductor layers 12, 18 may be comprised of germanium enriched in one or more stable isotopes having mass numbers with a nuclear spin of zero that are above (i.e., greater than) the natural abundance. In an embodiment, the concentration of germanium atoms with mass number 73 in the composite semiconductor layers 12, 18 may be less than the natural abundance of germanium atoms with mass number 73 and greater than zero atom percent (0 parts per million). In an embodiment, the concentration of germanium atoms with mass number 73 in the composite semiconductor layers 12, 18 may be less than the natural abundance of germanium atoms with mass number 73 and greater than 0.0005 atom percent (5 parts per million). In an embodiment, the concentration of germanium atoms with mass number 73 in the composite semiconductor layers 12, 18 may be less than half of the natural abundance of germanium atoms with mass number 73 and greater than zero atom percent (0 parts per million). In an embodiment, the concentration of germanium atoms with mass number 73 in the composite semiconductor layers 12, 18 may be less than half of the natural abundance of germanium atoms with mass number 73 and greater than 0.0005 atom percent (5 parts per million).

In an alternative embodiment, the semiconductor layer 12 may be initially comprised of single-crystal silicon-germanium containing stable isotopes of silicon and germanium present in their respective natural abundances, and the semiconductor layer 18 may be comprised of single-crystal silicon-germanium that is depleted in one or more of the stable isotopes. For example, before the anneal is performed, the semiconductor layer 18 may be comprised of silicon-germanium that is depleted of silicon atoms with mass number 29 to a concentration less than the natural abundance of silicon atoms with mass number 29 and also depleted of germanium atoms with mass number 73 to a concentration less than the natural abundance of germanium atoms with mass number 73.

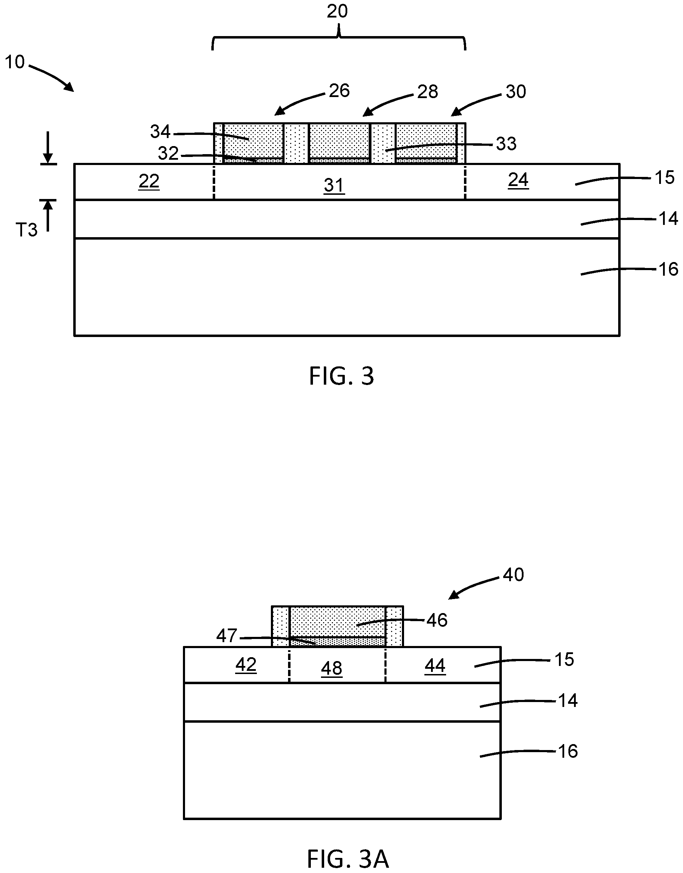

With reference to FIG. 3 in which like reference numerals refer to like features in FIG. 2 and at a subsequent fabrication stage, the semiconductor layers 12, 18 may be thinned by oxidation, cleaning, and/or chemical-mechanical polishing to provide a semiconductor layer 15 that is isotopically depleted and that has a thickness T3 suitable for forming an electronic device, such as a qubit device 20. In an embodiment, the semiconductor layer 18 may be fully removed such that the thickness T3 of the semiconductor layer 15 is less than or equal to the thickness T1 of the semiconductor layer 12. In an embodiment, the semiconductor layer 18 may be partially removed such that the thickness T3 of the semiconductor layer 15 is greater than the thickness T1 of the semiconductor layer 12. In an embodiment, the thickness T3 of the semiconductor layer 15 may range from about 3 nanometers to about 8 nanometers. The semiconductor layer 15 may be comprised of a single-crystal semiconductor material, such as single-crystal silicon, over the entire thickness T3.

The semiconductor layer 15 is disposed on the buried insulator layer 14, and the buried insulator layer 14 is disposed between the semiconductor layer 15 and the semiconductor substrate 16. The buried insulator layer 14 may fully separate the semiconductor layer 15 from the semiconductor substrate 16. The single-crystal semiconductor material of the semiconductor layer 15 may be disposed in direct contact with the buried insulator layer 16.

The semiconductor layer 15 may be comprised of a single-crystal semiconductor material having a concentration of an isotope with a nuclear spin of one-half (e.g., silicon with mass number 29) that is equal to the concentration in the semiconductor layers 12, 18 and therefore less than the natural abundance of the isotope. The semiconductor layer 15 may be comprised of a single-crystal semiconductor material enriched in atoms of an isotope with a nuclear spin of zero (e.g., silicon with mass number 28) to provide a concentration above (i.e., greater than) the natural abundance.

In an embodiment, the qubit device 20 may include a source region 22, a drain region 24, and gates 26, 28, 30 arranged laterally between the source region 22 and drain region 24. A portion of the isotopically-depleted semiconductor layer 15 beneath the gates 26, 28, 30 provides a channel region 31 between the source region 22 and drain region 24. The source region 22, the drain region 24 and 24, and the channel region 31 are depleted of atoms of silicon with mass number 29. Each of the gates 26, 28, 30 of the qubit device 20 may include a gate conductor layer 34 and a gate dielectric layer 32 that are formed in a layer stack with the gate dielectric layer 32 positioned between the gate conductor layer 34 and the channel region 31. In an embodiment, the gate conductor layer 34 may be comprised of a conductor, such as doped polysilicon or a work function metal, and the gate dielectric layer 32 may be comprised of a dielectric material, such as silicon dioxide or a high-k dielectric material. The spaces between the gates 26, 28, 30 may be filled by a dielectric material. The source region 22 and the drain region 24 of the qubit device 20 may be doped regions formed in semiconductor layer 15 by ion implantation of an n-type or p-type dopant into the semiconductor layer 15. Alternatively, the source region 22 and the drain region 24 of the qubit device 20 may be doped regions of semiconductor material formed on semiconductor layer 15 by epitaxial growth and in situ doped during epitaxial growth with an n-type or p-type dopant. In an alternative embodiment, the qubit device 20 may have a different construction.

The reduction of the concentration of atoms with a nuclear spin of non-integer spin in the isotopically-depleted semiconductor layer 15 and, in particular, in the channel region 31 may improve the functionality of the qubit device 20 and, for at least that reason, may improve the functionality of a quantum computer by depleting (i.e., reducing) the concentration of an isotope that has a non-integer nuclear spin (e.g., a nuclear spin of one-half) and enriching (i.e., increasing) the concentration of an isotope that has a nuclear spin of zero. For example, the stability of the qubit device 20 may be improved by reducing the decoherence of the qubit spin states that would otherwise arise from interactions of the qubit device 20 with atoms of an isotope having a non-integer nuclear spin.

With reference to FIG. 3A and in accordance with alternative embodiments, an active electronic device or a passive electronic device may be formed in a portion of the single-crystal semiconductor material of the semiconductor layer 15 different from the portion of the semiconductor layer 15 used to form the qubit device 20. For example, a transistor 40 may be formed by complementary-metal-oxide-semiconductor processing as an active electronic device in the portion of the semiconductor layer 15, such a field-effect transistor 40 including a source region 42, a drain region 44, and a gate 46 arranged laterally between the source region 42 and drain region 44. A portion of the semiconductor layer 15 beneath the gate 46 and a gate dielectric 47 provides a channel region 48 between the source region 42 and drain region 44.

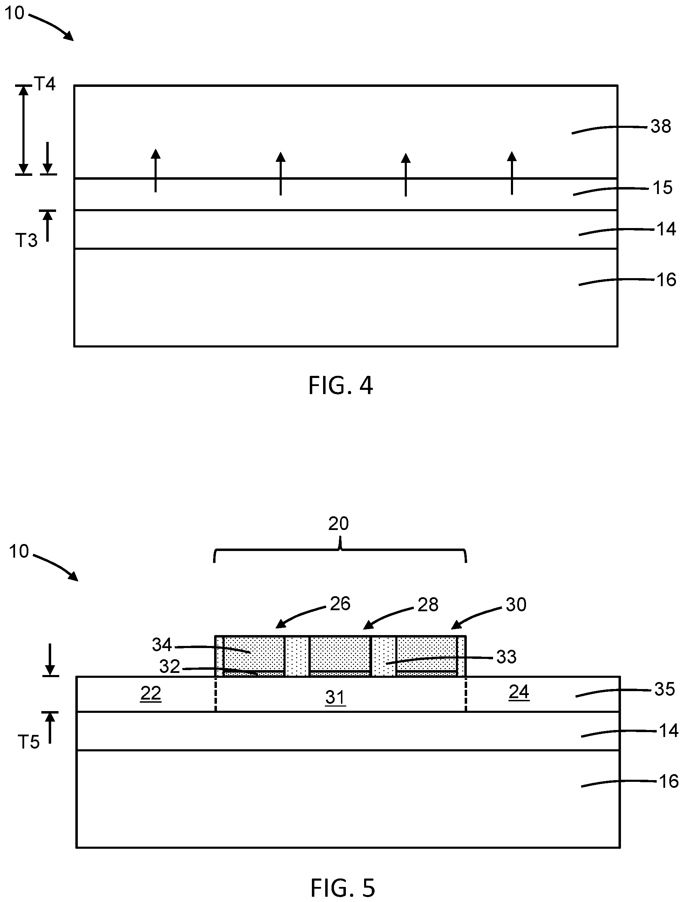

With reference to FIG. 4 and in accordance with alternative embodiments, a semiconductor layer 38 may be formed on the single-crystal semiconductor material of semiconductor layer 15 followed by another anneal. In an embodiment, the semiconductor layer 38 may be formed by an epitaxial growth process with a thickness T4 in a range of 50 nanometers to 150 nanometers. The semiconductor layer 38 may be comprised of a single-crystal semiconductor material, such as single-crystal silicon, that is depleted of silicon with mass number 29. In an embodiment, the semiconductor layer 38 may be a homoepitaxial layer that is comprised of the same semiconductor material as the semiconductor layer 15.

The anneal causes silicon atoms with mass number 29 to diffuse from the semiconductor layer 15 into the semiconductor layer 38, as diagrammatically shown by the single-headed arrows in FIG. 4. The result of the anneal is that the concentration of silicon atoms with mass number 29, which are originally only present in the thickness T1 of the semiconductor layer 15, is redistributed over the sum of the thickness T3 of the semiconductor layer 15 and the thickness T4 of the semiconductor layer 38. After the anneal, the concentration of silicon atoms with mass number 29 within the composite semiconductor layers 15, 38 is diluted to less than the initial concentration of silicon atoms with mass number 29 in the semiconductor layer 15. The post-anneal concentration of silicon atoms with mass number 29 in the composite semiconductor layers 15, 38 decreases with increasing thickness of the semiconductor layer 38. In an embodiment, the concentration of silicon atoms with mass number 29 in the semiconductor layers 15, 38 is less than the natural abundance of silicon atoms with mass number 29 and greater than 0.0005 (5 parts per million). The post-anneal concentration of silicon atoms with mass number 28 in the composite semiconductor layers 15, 38 is greater than the natural abundance of silicon atoms with mass number 28.

In an embodiment, additional iterations of forming an epitaxial semiconductor layer depleted of silicon atoms with mass number 29, annealing, and thinning may be performed. Each iteration beyond the initial iteration may further reduce the concentration of silicon atoms with mass number 29 so that the final concentration of silicon atoms with mass number 29 approaches that of the precursor used in the deposition of the semiconductor layer 18 or in the deposition of the semiconductor layer 38.

With reference to FIG. 5 in which like reference numerals refer to like features in FIG. 4 and at a subsequent fabrication stage, the semiconductor layers 15, 38 may be thinned to provide a semiconductor layer 35 that is isotopically depleted and that has a thickness T5 suitable for forming an electronic device, such as the qubit device 20. The semiconductor layer 35 may be comprised of a single-crystal semiconductor material, such as single-crystal silicon, over the entire thickness T5. In an embodiment, the semiconductor layer 38 may be fully removed such that the thickness T5 of the semiconductor layer 35 is less than or equal to the thickness T3 of the semiconductor layer 15. In an embodiment, the semiconductor layer 38 may be partially removed such that the thickness T5 of the semiconductor layer 35 is greater than the thickness T3 of the semiconductor layer 15. In an embodiment, the thickness T5 of the semiconductor layer 35 may range from about 3 nanometers to about 8 nanometers. The thinned semiconductor layer 35 has a concentration of silicon atoms with mass number 29 equal to the concentration in the semiconductor layers 15, 38. The semiconductor layer 35 may be comprised of silicon enriched in silicon atoms with mass number 28 above (i.e., greater than) the natural abundance.

The methods as described above are used in the fabrication of integrated circuit chips. The resulting integrated circuit chips can be distributed by the fabricator in raw wafer form (e.g., as a single wafer that has multiple unpackaged chips), as a bare die, or in a packaged form. The chip may be integrated with other chips, discrete circuit elements, and/or other signal processing devices as part of either an intermediate product or an end product. The end product can be any product that includes integrated circuit chips, such as computer products having a central processor or smartphones.

References herein to terms modified by language of approximation, such as "about", "approximately", and "substantially", are not to be limited to the precise value specified. The language of approximation may correspond to the precision of an instrument used to measure the value and, unless otherwise dependent on the precision of the instrument, may indicate a range of +/- 10% of the stated value(s).

References herein to terms such as "vertical", "horizontal", etc. are made by way of example, and not by way of limitation, to establish a frame of reference. The term "horizontal" as used herein is defined as a plane parallel to a conventional plane of a semiconductor substrate, regardless of its actual three-dimensional spatial orientation. The terms "vertical" and "normal" refer to a direction perpendicular to the horizontal, as just defined. The term "lateral" refers to a direction within the horizontal plane.

A feature "connected" or "coupled" to or with another feature may be directly connected or coupled to or with the other feature or, instead, one or more intervening features may be present. A feature may be "directly connected" or "directly coupled" to or with another feature if intervening features are absent. A feature may be "indirectly connected" or "indirectly coupled" to or with another feature if at least one intervening feature is present. A feature "on" or "contacting" another feature may be directly on or in direct contact with the other feature or, instead, one or more intervening features may be present. A feature may be "directly on" or in "direct contact" with another feature if intervening features are absent. A feature may be "indirectly on" or in "indirect contact" with another feature if at least one intervening feature is present. Different features may "overlap" if a feature extends over, and covers a part of, another feature with either direct contact or indirect contact.

The descriptions of the various embodiments of the present invention have been presented for purposes of illustration but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

In summary, structures that include an isotopically-depleted semiconductor layer and methods of forming such structures are provided. The structure comprises a semiconductor layer comprising a semiconductor material having an isotope with a concentration that is less than a natural abundance of the first isotope and greater than zero parts per million.

The following embodiments are explicitly disclosed.

### Embodiment 1:

A structure comprising:
a semiconductor layer comprising a semiconductor material having a first isotope with a first concentration of atoms, the first concentration of atoms in the semiconductor material less than a natural abundance of the first isotope and greater than zero parts per million. The semiconductor material may preferably comprise at least one of silicon and germanium.

### Embodiment 2:

The structure of embodiment 1, wherein the first isotope has a non-integer nuclear spin.

### Embodiment 3:

The structure of embodiment 1 or 2, wherein the semiconductor material is silicon, and the first isotope has mass number 29.

### Embodiment 4:

The structure of one of embodiments 1 to 3, wherein the semiconductor material is germanium, and the first isotope has mass number 73.

### Embodiment 5:

The structure of one of embodiments 1 to 4, wherein the semiconductor material has a second isotope with a second concentration of atoms that is less than a natural abundance of the second isotope and greater than zero parts per million.

### Embodiment 6:

The structure of embodiment 5, wherein the semiconductor material is silicon-germanium.

### Embodiment 7:

The structure of embodiment 5 or 6, wherein the first isotope has mass number 29, and the second isotope has mass number 73.

### Embodiment 8:

The structure of one of embodiments 5 to 7, wherein the first isotope has a non-integer nuclear spin, and the second isotope has a non-integer nuclear spin.

### Embodiment 9:

The structure of one of embodiments 5 to 8, wherein the semiconductor material has a third isotope with a third concentration of atoms that is greater than a natural abundance of the third isotope, and the third isotope has nuclear spin of zero.

### Embodiment 10:

The structure of one of embodiments 1 to 9, wherein the semiconductor material has a second isotope with a second concentration of atoms, the second concentration of atoms is greater than a natural abundance of the second isotope, and the second isotope has nuclear spin of zero.

### Embodiment 11:

The structure of one of embodiments 1 to 10, further comprising:
a field-effect transistor having a channel region in the semiconductor layer.

### Embodiment 12:

The structure of one of embodiments 1 to 11, further comprising:
a qubit device having a channel region in the semiconductor layer.

### Embodiment 13:

The structure of one of embodiments 1 to 12, wherein the semiconductor material of the semiconductor layer is a single-crystal semiconductor material.

### Embodiment 14:

The structure of one of embodiments 1 to 13, further comprising:
a buried insulator layer; and
a semiconductor substrate,
wherein the buried insulator layer is disposed between the semiconductor substrate and the buried insulator layer.

### Embodiment 15:

The structure of one of embodiments 1 to 14, wherein the semiconductor layer has a thickness in a range from about 3 nanometers to about 8 nanometers, and the semiconductor material of the semiconductor layer is a single-crystal semiconductor material.

### Embodiment 16:

A method comprising:
forming a first semiconductor layer comprising a semiconductor material having a first isotope with a first concentration of atoms,
wherein the first concentration of atoms in the semiconductor material is less than a natural abundance of the first isotope and greater than zero parts per million.

### Embodiment 17:

The method of embodiment 16, wherein forming the first semiconductor layer comprising the semiconductor material having the first isotope with the first concentration of atoms comprises:
forming a second semiconductor layer on a third semiconductor layer,
wherein the second semiconductor layer has a second concentration of atoms of the first isotope of the semiconductor material that is less than the natural abundance, and the third semiconductor layer has a third concentration of atoms of the first isotope of the semiconductor material that is equal to the natural abundance.

### Embodiment 18:

The method of embodiment 17, wherein the second semiconductor layer is thicker than the third semiconductor layer.

### Embodiment 19:

The method of embodiment 17 or 18, wherein forming the first semiconductor layer comprising the semiconductor material having the first isotope with the first concentration of atoms further comprises:
annealing the second semiconductor layer and the third semiconductor layer.

### Embodiment 20:

The method of one of embodiments 16 to 19, wherein forming the first semiconductor layer comprising the semiconductor material having the first isotope with the first concentration of atoms further comprises:
thinning the second semiconductor layer and the third semiconductor layer to form the first semiconductor layer.

### Embodiment 21:

The method of one of embodiments 16 to 20, further comprising:
forming a qubit device having a channel in a first portion of the first semiconductor layer.

### Embodiment 22:

The method of embodiment 21 further comprising:
forming an active electronic device or a passive electronic device in a second portion of the first semiconductor layer.

### Embodiment 23:

The method of one of embodiments 16 to 22, wherein the structure of one of embodiments 1 to 15 is formed.

## Claims

1. A structure comprising:
a semiconductor layer comprising a semiconductor material having a first isotope with a first concentration of atoms, the first concentration of atoms in the semiconductor material less than a natural abundance of the first isotope and greater than zero parts per million, wherein the semiconductor material preferably comprises at least one of silicon and germanium.

2. The structure of claim 1, wherein the first isotope has a non-integer nuclear spin.

3. The structure of claim 1 or 2, wherein the semiconductor material is silicon and the first isotope has mass number 29, and/or wherein the semiconductor material is germanium and the first isotope has mass number 73.

4. The structure of one of claims 1 to 3, wherein the semiconductor material has a second isotope with a second concentration of atoms that is less than a natural abundance of the second isotope and greater than zero parts per million.

5. The structure of claim 4, wherein the semiconductor material is silicon-germanium; and/or
wherein the first isotope has mass number 29, and the second isotope has mass number 73; and/or
wherein the first isotope has a non-integer nuclear spin, and the second isotope has a non-integer nuclear spin; and/or
wherein the semiconductor material has a third isotope with a third concentration of atoms that is greater than a natural abundance of the third isotope, and the third isotope has nuclear spin of zero.

6. The structure of one of claims 1 to 3, wherein the semiconductor material has a second isotope with a second concentration of atoms, the second concentration of atoms is greater than a natural abundance of the second isotope, and the second isotope has nuclear spin of zero.

7. The structure of one of claims 1 to 6, further comprising:
a field-effect transistor having a channel region in the semiconductor layer; and/or
a qubit device having a channel region in the semiconductor layer.

8. The structure of one of claims 1 to 7, wherein the semiconductor material of the semiconductor layer is a single-crystal semiconductor material.

9. The structure of one of claims 1 to 8, further comprising:
a buried insulator layer; and
a semiconductor substrate,
wherein the buried insulator layer is disposed between the semiconductor substrate and the buried insulator layer.

10. The structure of one of claims 1 to 9, wherein the semiconductor layer has a thickness in a range from about 3 nanometers to about 8 nanometers, and the semiconductor material of the semiconductor layer is a single-crystal semiconductor material.

11. A method comprising:
forming a first semiconductor layer comprising a semiconductor material having a first isotope with a first concentration of atoms,
wherein the first concentration of atoms in the semiconductor material is less than a natural abundance of the first isotope and greater than zero parts per million.

12. The method of claim 11, wherein forming the first semiconductor layer comprising the semiconductor material having the first isotope with the first concentration of atoms comprises:
forming a second semiconductor layer on a third semiconductor layer,
wherein the second semiconductor layer has a second concentration of atoms of the first isotope of the semiconductor material that is less than the natural abundance, and the third semiconductor layer has a third concentration of atoms of the first isotope of the semiconductor material that is equal to the natural abundance.

13. The method of claim 12, wherein the second semiconductor layer is thicker than the third semiconductor layer.

14. The method of claim 12 or 13, wherein forming the first semiconductor layer comprising the semiconductor material having the first isotope with the first concentration of atoms further comprises:
annealing the second semiconductor layer and the third semiconductor layer,
wherein forming the first semiconductor layer comprising the semiconductor material having the first isotope with the first concentration of atoms preferably further comprises:
thinning the second semiconductor layer and the third semiconductor layer to form the first semiconductor layer.

15. The method of one of claims 11 to 14, further comprising:
forming a qubit device having a channel in a first portion of the first semiconductor layer,
wherein the method preferably further comprises forming an active electronic device or a passive electronic device in a second portion of the first semiconductor layer.
